# FASCICULE DE BREVET EUROPEEN

(11) **EP 3 175 488 B1**
(45) Date de publication et mention de la délivrance du brevet: **16.05.2018**
(21) Numéro de dépôt: 15742258.5
(22) Date de dépôt: 27.07.2015
(51) Int. Cl.: H01L 31/048, H02S 20/00, H01L 31/18

(54) **MODULE PHOTOVOLTAÏQUE POUR SUPPORT RIGIDE**
FOTOVOLTAIKMODUL FÜR EINEN STARREN TRÄGER
PHOTOVOLTAIC MODULE FOR A RIGID CARRIER

(30) Priorité: 28.07.2014 FR 1457277
(43) Date de publication de la demande: 07.06.2017
(73) Titulaire: Commissariat à l'Énergie Atomique et aux Énergies Alternatives, 75015 Paris (FR)
(72) Inventeur: GAUME, Julien, 38110 La Tour Du Pin (FR); GUILLEREZ, Stéphane, 73610 Lepin Le Lac (FR); SICOT, Lionel, 73000 Chambery (FR)
(74) Mandataire: Brevalex
(86) Numéro de dépôt international: PCT/EP2015/067116
(87) Numéro de publication internationale: WO 2016/016170

(56) Documents cités:
- EP-A1- 1 030 376
- US-A1- 2008 000 517
- US-A1- 2013 153 008

## Description

### DOMAINE TECHNIQUE

La présente invention se rapporte au domaine des modules photovoltaïques, comportant un ensemble de cellules photovoltaïques reliées entre elles électriquement, et notamment des cellules photovoltaïques dites « cristallines », c'est-à-dire qui sont à base de cristaux de silicium ou de polycristaux de silicium.

L'invention peut être mise en oeuvre pour de nombreuses applications, étant particulièrement concernée par les applications qui requièrent l'utilisation de modules photovoltaïques légers, flexibles et robustes vis-à-vis de chocs et de charges mécaniques élevées. Elle peut ainsi notamment être appliquée pour des bâtiments tels que des habitats ou locaux industriels, par exemple pour la réalisation de leurs toitures, pour la conception de mobilier urbain, par exemple pour de l'éclairage public, la signalisation routière ou encore la recharge de voitures électriques, ou également pour son intégration sur des zones circulables, pour des piétons et/ou des véhicules, telles que des chaussées ou routes, des pistes cyclables, des plateformes industrielles, des places, des trottoirs, entre autres. Cette dernière application est couramment désignée par l'expression de « route solaire ».

L'invention propose ainsi un module photovoltaïque convenant en particulier pour être appliqué sur un support rigide, un ensemble de structure photovoltaïque comportant un tel module photovoltaïque, l'utilisation d'un tel module photovoltaïque pour son application sur un support rigide, ainsi qu'un procédé de réalisation d'un tel module ou d'un tel ensemble de structure photovoltaïque.

### ÉTAT DE LA TECHNIQUE ANTÉRIEURE

Un module photovoltaïque, tel que celui décrit dans le document US 2013/153008 A1, est un assemblage de cellules photovoltaïques disposées côte à côte entre une première couche transparente formant une face avant du module photovoltaïque et une seconde couche formant une face arrière du module photovoltaïque.

La première couche formant la face avant du module photovoltaïque est avantageusement transparente pour permettre aux cellules photovoltaïques de recevoir un flux lumineux. Elle est traditionnellement réalisée en une seule plaque de verre, présentant une épaisseur de l'ordre de 3 mm. La deuxième couche formant la face arrière du module photovoltaïque peut quant à elle être réalisée à base de verre, de métal ou de plastique, entre autres. Elle est habituellement formée par une structure polymérique à base d'un polymère isolant électrique, par exemple du type polytéréphtalate d'éthylène (PET) ou polyamide (PA), pouvant être protégée par une ou des couches à base de polymères fluorés, comme le polyfluorure de vinyle (PVF) ou le polyfluorure de vinylidène (PVDF), et ayant une épaisseur de l'ordre de 300 µm.

Les cellules photovoltaïques peuvent être reliées électriquement en série entre elles par des éléments de contact électrique avant et arrière, appelés conducteurs de liaison, et formés par exemple par des bandes de cuivre, respectivement disposées contre les faces avant (faces se trouvant en regard de la face avant du module photovoltaïque destinée à recevoir un flux lumineux) et arrière (faces se trouvant en regard de la face arrière du module photovoltaïque) de chacune des cellules photovoltaïques.

Par ailleurs, les cellules photovoltaïques, situées entre les première et deuxième couches formant respectivement les faces avant et arrière du module photovoltaïque, sont encapsulées. De façon classique, l'encapsulant choisi correspond à un polymère du type élastomère (ou caoutchouc), et peut par exemple consister en l'utilisation de deux couches (ou films) de poly(éthylène-acétate de vinyle) (EVA) entre lesquelles sont disposées les cellules photovoltaïques et les conducteurs de liaison des cellules. Chaque couche d'EVA peut présenter une épaisseur d'au moins 0,3 mm et un module de Young inférieur ou égal à 30 MPa à température ambiante.

Habituellement encore, le procédé de réalisation du module photovoltaïque comporte une seule étape de laminage des différentes couches décrites précédemment, à une température supérieure ou égale à 140°C, voire 150°C, et pendant une période d'au moins 8 minutes, voire 15 minutes. Après cette opération de laminage, les deux couches d'EVA ont fondu pour ne former qu'une seule couche dans laquelle sont noyées les cellules photovoltaïques.

Néanmoins, ces réalisations connues de l'art antérieur d'un module photovoltaïque ne sont pas entièrement satisfaisantes et présentent plusieurs inconvénients pour au moins certaines de leurs applications.

Par exemple, dans le cadre de l'application du type route solaire, un besoin est apparu pour utiliser les routes ou chaussées comme moyens de production d'énergie pendant la journée, que ce soit pour alimenter des bâtiments situés à proximité (entreprises, éco-quartiers, fermes solaires, maisons individuelles, entre autres) ou pour alimenter le réseau électrique ou des dispositifs d'aide à la circulation, par exemple.

Ainsi, tout d'abord, la présence d'une plaque de verre pour former la face avant du module photovoltaïque n'est pas compatible avec certaines applications du module photovoltaïque qui peuvent requérir une relative légèreté et une facilité de mise en forme du module. Au contraire, les conceptions de l'art antérieur utilisant du verre en face avant des modules photovoltaïques impliquent l'obtention d'un poids élevé du module et une capacité d'intégration limitée.

Pour une application du type route solaire, les modules photovoltaïques avec une face avant réalisée en verre ne sont, d'une part, pas suffisamment flexibles pour répondre à la déformation d'une route, celle-ci étant de l'ordre d'1 mm tous les 100 mm pour les deux axes horizontaux, selon la largeur et la longueur, de la route. D'autre part, ces modules photovoltaïques ne sont pas suffisamment résistants à la charge statique s'ils sont collés directement sur la chaussée. Autrement dit, la rugosité de la chaussée peut provoquer un poinçonnement des cellules photovoltaïques par la face arrière du module photovoltaïque, entraînant alors des risques de cassure des cellules photovoltaïques.

Des solutions ont été envisagées pour remplacer la face avant en verre des modules photovoltaïques par des matériaux plastiques, tout en conservant l'architecture et la méthode de réalisation classiques des modules photovoltaïques. A titre d'exemples, la demande de brevet FR 2 955 051 A1 et les demandes internationales WO 2012/140585 A1 et WO 2011/028513 A2 décrivent des possibilités d'alternatives au verre pour concevoir la face avant des modules photovoltaïques, parmi lesquelles l'utilisation de feuilles de polymère, d'une épaisseur inférieure ou égale à 500 µm, comme le polyfluorure de vinylidène (PVDF), l'éthylène tétrafluoroéthylène (ETFE), le polyméthacrylate de méthyle (PMMA) ou encore le polycarbonate (PC).

Cependant, la simple substitution du verre par un matériau polymère, afin d'obtenir un module photovoltaïque léger et flexible, entraîne généralement une vulnérabilité accrue du module aux chocs et aux charges mécaniques, non acceptable pour certaines applications.

De plus, dans ces exemples de réalisation de l'art antérieur, la face avant (dépourvue de verre) de chaque module photovoltaïque est continue, c'est-à-dire qu'elle forme une feuille ou une plaque unitaire qui recouvre l'ensemble du module. De la sorte, la flexibilité de chaque module photovoltaïque peut être limitée et surtout non suffisante. Par ailleurs, cela pose également un problème d'accentuation de contraintes différentielles de dilatation entre les différentes couches de la structure, pouvant conduire à des déformations ou des décollements indésirables aux interfaces de la structure, comme par exemple à l'interface encapsulant/couches externes.

Il a été proposé certaines solutions visant à obtenir une relative discontinuité de la face avant d'un module photovoltaïque afin d'obtenir une meilleure flexibilité du module et de mieux gérer les contraintes de dilatation différentielle. Ainsi, par exemple, la demande de brevet US 2014/0000683 A1 décrit une méthode pour encapsuler des cellules photovoltaïques de manière individuelle. Les cellules encapsulées peuvent ensuite être interconnectées pour obtenir un module photovoltaïque souple. Par ailleurs, la demande de brevet US 2014/0030841 A1 enseigne la mise en oeuvre d'un module photovoltaïque sur un substrat flexible. Le module photovoltaïque est composé de « sous-modules » constitués de cellules photovoltaïques interconnectées, chaque sous-module étant indépendant électriquement des sous-modules voisins.

Toutefois, les solutions décrites ci-dessus ne s'avèrent pas totalement satisfaisantes en termes de flexibilité, de résistance aux chocs et aux charges mécaniques, de performance et de coût des modules photovoltaïques, en particulier pour des applications contraignantes qui les sollicitent fortement au niveau de leur résistance mécanique.

### EXPOSÉ DE L'INVENTION

Il existe ainsi un besoin pour proposer une solution alternative de conception d'un module photovoltaïque pour répondre à au moins certaines contraintes inhérentes aux applications visées par l'utilisation du module photovoltaïque, en particulier pour améliorer la flexibilité, la rigidité, la légèreté et la résistance aux chocs et charges mécaniques du module photovoltaïque.

L'invention a pour but de remédier au moins partiellement aux besoins mentionnés ci-dessus et aux inconvénients relatifs aux réalisations de l'art antérieur.

L'invention a ainsi pour objet, selon l'un de ses aspects, un module photovoltaïque, convenant en particulier pour être appliqué sur un support rigide, comportant au moins :
- une première couche transparente formant la face avant du module photovoltaïque destinée à recevoir un flux lumineux,
- un ensemble d'une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, destinée en particulier à être solidarisée à un support rigide, l'ensemble encapsulant et l'ensemble d'une pluralité de cellules photovoltaïques étant situés entre les première et deuxième couches,
caractérisé en ce que la première couche est constituée d'au moins un matériau polymère transparent et comporte une pluralité de plaques indépendantes les unes des autres, chaque plaque étant située en regard d'au moins une cellule photovoltaïque, de sorte à former une face avant discontinue du module photovoltaïque,
et en ce que la rigidité de l'ensemble encapsulant est définie par un module de Young du matériau d'encapsulation supérieur ou égal à 75 MPa à température ambiante et une épaisseur de l'ensemble encapsulant comprise entre 0,4 et 1 mm.

Initialement, c'est-à-dire avant toute opération de laminage, l'ensemble encapsulant est constitué par deux couches de matériau d'encapsulation, dites couches de coeur, entre lesquelles l'ensemble d'une pluralité de cellules photovoltaïques est encapsulé. Toutefois, après l'opération de laminage des couches, les couches de matériau d'encapsulation ont fondu pour ne former qu'une seule couche (ou ensemble) dans laquelle sont noyées les cellules photovoltaïques. Avant toute opération de laminage, chaque couche de matériau d'encapsulation peut ainsi présenter une rigidité définie par un module de Young à température ambiante du matériau d'encapsulation supérieur ou égal à 75 MPa et une épaisseur de la couche comprise entre 0,2 et 1 mm, voire entre 0,2 et 0,5 mm.

L'ensemble encapsulant la pluralité de cellules photovoltaïques est ainsi constitué par les deux couches de matériau d'encapsulation, à savoir les couches de matériau d'encapsulation qui avant laminage sont en contact direct avec les cellules photovoltaïques.

Le terme « transparent » signifie que le matériau de la première couche formant la face avant du module photovoltaïque est au moins partiellement transparent à la lumière visible, laissant passer au moins environ 80 % de cette lumière.

De plus, par l'expression « plaques indépendantes les unes des autres », on entend que les plaques sont situées à distance les unes des autres, formant chacune un élément unitaire indépendant de la première couche et les uns des autres, superposé à au moins une cellule photovoltaïque. La réunion de l'ensemble de ces plaques forme alors la première couche avec un aspect discontinu.

En outre, par le terme « encapsulant » ou « encapsulé », il faut comprendre que l'ensemble d'une pluralité de cellules photovoltaïques est disposé dans un volume, par exemple hermétiquement clos, au moins en partie formé par les couches de matériau d'encapsulation, réunies entre elles après laminage.

Le module photovoltaïque peut être appliqué sur un support rigide, lequel peut, dans un exemple particulier de réalisation de l'invention, être une zone circulable. L'expression « zone circulable » désigne toute zone prévue pour la circulation de piétons et/de véhicules, telles que par exemple une chaussée (ou route), une autoroute, une piste cyclable, une plateforme industrielle, une place, un trottoir, cette liste étant nullement limitative.

Par ailleurs, par l'expression « température ambiante », on entend une température comprise entre environ 15 et 30°C.

Grâce à l'invention, il peut ainsi être possible d'apporter une solution alternative pour la conception d'un module photovoltaïque souple et relativement flexible, et également suffisamment robuste pour résister à des chocs et des charges mécaniques subis, notamment après application sur un support rigide. En particulier, l'utilisation d'une face avant discontinue peut conférer au module photovoltaïque selon l'invention un caractère flexible permettant notamment de faciliter son application sur un support non plan, par exemple courbé. De plus, l'utilisation d'un matériau d'encapsulation de rigidité élevée pour l'ensemble encapsulant les cellules photovoltaïques peut permettre de protéger convenablement les cellules photovoltaïques contre le risque d'une forte charge mécanique ou d'un choc, en limitant leur flexion, et donc en limitant le risque de cassure. En outre, l'absence d'usage d'un matériau en verre pour la face avant du module photovoltaïque peut permettre au module photovoltaïque selon l'invention de présenter un poids inférieur à celui d'un module photovoltaïque selon l'art antérieur, typiquement de l'ordre de 12 kg/m², en fonction de l'épaisseur des différentes couches utilisées. Enfin, l'utilisation d'une face avant discontinue en un matériau polymère peut permettre de se prémunir de problèmes de dilatation thermique au cours de l'emploi du module photovoltaïque selon l'invention en extérieur. En effet, la dilatation thermique étant proportionnelle aux dimensions de la première couche formant la face avant du module, le fait d'utiliser des plaques ayant des dimensions proches de celles des cellules photovoltaïques peut permettre de limiter significativement les déplacements induits par des contraintes thermiques pouvant donner lieu à des délaminations ou une conformation non contrôlée du module photovoltaïque.

Le module photovoltaïque selon l'invention peut en outre comporter l'une ou plusieurs des caractéristiques suivantes prises isolément ou suivant toutes combinaisons techniques possibles.

La deuxième couche formant la face arrière du module photovoltaïque peut également être discontinue. Autrement dit, la deuxième couche peut également comporter une pluralité de plaques indépendantes les unes des autres, chaque plaque étant située en regard, c'est-à-dire superposée, d'au moins une cellule photovoltaïque. La présence d'une face arrière discontinue sur le module photovoltaïque selon l'invention peut par exemple permettre d'améliorer encore la flexibilité du module pour faciliter son application sur un support rigide pourvu d'une rugosité de surface.

Par ailleurs, quand bien même la première couche formant la face avant du module photovoltaïque selon l'invention, et éventuellement la deuxième couche formant la face arrière du module, présentent un aspect discontinu, l'ensemble d'une pluralité de cellules photovoltaïques et l'ensemble encapsulant sont avantageusement continues.

Selon un mode de réalisation particulier de l'invention, chaque plaque de la première couche, et éventuellement de la deuxième couche, peut être située en regard de plusieurs cellules photovoltaïques. Cela peut notamment être le cas pour des cellules photovoltaïques de dimensions plus faibles que celles des cellules photovoltaïques classiques, typiquement de 156 x 156 mm.

De plus, lorsqu'une seule cellule photovoltaïque est située en regard de chaque plaque de la première couche, et éventuellement de la deuxième couche, chaque plaque peut présenter des dimensions au moins égales à celles de la cellule photovoltaïque à laquelle elle est superposée.

Le module photovoltaïque est avantageusement dépourvu d'une première couche formant la face avant du module réalisée en verre. Ainsi, comme indiqué précédemment, il peut être possible d'améliorer la légèreté et la capacité d'intégration du module photovoltaïque.

Le matériau d'encapsulation formant les deux couches de matériau d'encapsulation de coeur de l'ensemble encapsulant peut présenter un module de Young à température ambiante supérieur ou égal à 100 MPa, notamment supérieur ou égal à 150 MPa, voire 200 MPa. Il est notamment de 220 MPa.

L'ensemble encapsulant peut être formé à partir de deux couches de matériau d'encapsulation ayant des épaisseurs identiques ou différentes.

La deuxième couche formant la face arrière du module photovoltaïque peut être constituée d'au moins un matériau polymère.

En variante, la deuxième couche formant la face arrière du module photovoltaïque peut être constituée d'au moins un matériau composite, notamment du type polymère/fibres de verre.

La deuxième couche a par ailleurs, de préférence, un coefficient de dilatation thermique inférieur ou égal à 20 ppm, et de préférence inférieur ou égal à 10 ppm.

La deuxième couche formant la face arrière du module photovoltaïque peut être ou non transparente.

La rigidité de la deuxième couche formant la face arrière du module photovoltaïque peut être définie par un facteur de rigidité, correspondant au module de Young à température ambiante du matériau de la deuxième couche multiplié par l'épaisseur de la deuxième couche, compris entre 5 et 15 GPa.mm.

De plus, la rigidité de la deuxième couche formant la face arrière du module photovoltaïque peut être définie par un module de Young à température ambiante du matériau de la deuxième couche supérieur ou égal à 1 GPa, mieux supérieur ou égal à 3 GPa, encore mieux supérieur ou égal à 10 GPa, et une épaisseur de la deuxième couche comprise entre 0,2 et 3 mm.

De cette façon, la deuxième couche formant la face arrière du module photovoltaïque peut présenter une rigidité élevée, pouvant limiter ainsi sa flexibilité. Toutefois, cette rigidité élevée peut permettre de réduire, voire d'empêcher, le poinçonnement des cellules photovoltaïques par la face arrière du module, c'est-à-dire l'apparition de fissures et/ou de cassures des cellules photovoltaïques, lorsque celui-ci est appliqué sur un support présentant une rugosité de surface importante.

L'espacement entre deux cellules photovoltaïques voisines, ou encore consécutives ou adjacentes, peut être supérieur ou égal à 1 mm, notamment compris entre 1 et 30 mm, et de préférence supérieur ou égal à 3 mm, notamment compris entre 10 et 20 mm.

Les deux cellules photovoltaïques voisines considérées peuvent être deux cellules voisines d'une même série (encore désignée par le terme « string » en anglais) ou deux cellules voisines appartenant respectivement à deux séries consécutives de l'ensemble de cellules photovoltaïques.

La présence d'un important espacement entre les cellules photovoltaïques peut permettre d'obtenir un espacement également important entre les plaques de la première couche formant la face avant du module photovoltaïque. De cette façon, l'aspect discontinu de la face avant du module est accentué, permettant ainsi de conférer une flexibilité au module pour faciliter son application sur le support rigide.

De façon avantageuse, l'espacement entre deux plaques voisines de la première couche, et éventuellement de la deuxième couche, est inférieur ou égal à l'espacement entre deux cellules photovoltaïques voisines.

Selon une variante, le module photovoltaïque peut comporter une couche intermédiaire dite « amortissante » située entre la première couche formant la face avant du module photovoltaïque et l'ensemble encapsulant la pluralité de cellules photovoltaïques, permettant l'assemblage, notamment par collage, de la première couche sur l'ensemble encapsulant.

La couche intermédiaire peut être constituée d'au moins un matériau polymère, notamment d'une résine polymère thermoplastique ou thermodurcissable.

La couche intermédiaire peut se présenter par exemple sous forme de feuille ou sous forme liquide. Elle peut être adhésive, par exemple du type PSA, ou non. Elle peut être mise en oeuvre à chaud ou encore à température ambiante.

La rigidité de la couche intermédiaire peut être définie par un module de Young du matériau de la couche intermédiaire inférieur ou égal à 50 MPa à température ambiante et une épaisseur de la couche intermédiaire comprise entre 0,01 et 1 mm.

La couche intermédiaire peut en particulier remplir deux fonctions principales. D'une part, elle peut permettre l'adhésion de la première couche formant la face avant du module photovoltaïque sur l'ensemble encapsulant pour le cas où les deux couches ne sont pas compatibles chimiquement. D'autre part, elle peut permettre de créer au sein du module photovoltaïque une couche « amortissante » d'une certaine souplesse permettant d'améliorer la résistance aux chocs et aux charges mécaniques du module.

Cette couche intermédiaire peut être optionnelle, en particulier absente lorsqu'il y a compatibilité chimique entre la première couche formant la face avant du module photovoltaïque et l'ensemble encapsulant.

Le module photovoltaïque peut en outre comporter une couche adhésive située entre la deuxième couche formant la face arrière du module photovoltaïque et l'ensemble encapsulant la pluralité de cellules photovoltaïques, permettant l'assemblage, notamment par collage, de la deuxième couche sur l'ensemble encapsulant.

Par « couche adhésive », on entend une couche permettant, une fois le module photovoltaïque réalisé, à la deuxième couche d'adhérer à l'ensemble encapsulant. Il s'agit ainsi d'une couche permettant une compatibilité chimique et une adhésion entre l'encapsulant et la face arrière.

Par ailleurs, l'épaisseur de la première couche formant la face avant du module photovoltaïque peut être supérieure ou égale à 0,1 mm, notamment comprise entre 0,5 et 6 mm.

En outre, l'invention a encore pour objet, selon un autre de ses aspects, un ensemble de structure photovoltaïque, comportant :
- un support rigide,
- un module photovoltaïque tel que défini précédemment, et
- une couche de fixation, notamment par collage, située entre le support rigide et le module photovoltaïque, permettant l'adhérence du module photovoltaïque au support rigide.

Le support rigide peut présenter une rugosité de surface.

Selon une variante de réalisation, la couche de fixation peut être constituée par une colle bitumeuse.

L'utilisation de la couche de fixation peut permettre d'obtenir une face arrière du module photovoltaïque renforcée, permettant d'éviter le risque de poinçonnement des cellules photovoltaïques par la face arrière lorsque le support rigide présente une rugosité de surface élevée et que le module photovoltaïque est soumis à un choc ou une charge mécanique élevée. En effet, l'interface entre la face arrière du module et le support rigide peut ainsi être comblée par un liant de protection.

En outre, l'invention a également pour objet, selon un autre de ses aspects, l'utilisation, pour son application sur un support rigide d'un module photovoltaïque comportant au moins :
- une première couche transparente formant la face avant du module photovoltaïque destinée à recevoir un flux lumineux,
- un ensemble d'une pluralité de cellules photovoltaïques disposées côte à côte et reliées électriquement entre elles,
- un ensemble encapsulant la pluralité de cellules photovoltaïques,
- une deuxième couche formant la face arrière du module photovoltaïque, l'ensemble encapsulant et l'ensemble d'une pluralité de cellules photovoltaïques étant situés entre les première et deuxième couches,
la première couche étant constituée d'au moins un matériau polymère transparent étant du polyméthacrylate de méthyle (PMMA) choc nanostructuré, et comportant une pluralité de plaques indépendantes les unes des autres, chaque plaque étant située en regard d'au moins une cellule photovoltaïque, de sorte à former une face avant discontinue du module photovoltaïque,
et la rigidité de l'ensemble encapsulant étant définie par un module de Young du matériau d'encapsulation supérieur ou égal à 75 MPa à température ambiante et une épaisseur de l'ensemble encapsulant comprise entre 0,4 et 1 mm,
le module photovoltaïque étant appliqué sur le support rigide par l'intermédiaire d'une couche de fixation.

Par ailleurs, l'invention a encore pour objet, selon un autre de ses aspects, un procédé de réalisation d'un module photovoltaïque tel que défini précédemment ou d'un ensemble de structure photovoltaïque tel que défini précédemment, comportant au moins les deux étapes successives suivantes de :
a) laminage à chaud à une température supérieure à 150°C, de l'ensemble des couches constitutives du module photovoltaïque hormis la première couche formant la face avant du module photovoltaïque et une éventuelle couche intermédiaire dite « amortissante », située entre la première couche et l'ensemble encapsulant la pluralité de cellules photovoltaïques,
b) laminage à une température inférieure ou égale à 150°C, mieux 125°C, par exemple à température ambiante, de la première couche formant la face avant du module photovoltaïque, et de l'éventuelle couche intermédiaire, sur les couches constitutives du module photovoltaïque laminées ensemble au cours de la première étape a).

Lors de la première étape a) de laminage, les couches constitutives du module photovoltaïque concernées sont ainsi l'ensemble d'une pluralité de cellules photovoltaïques, l'ensemble encapsulant et la deuxième couche formant la face arrière du module photovoltaïque.

L'éventuelle couche intermédiaire dite « amortissante » peut permettre de faciliter le collage de la première couche formant la face avant du module sur les autres couches. Cette couche intermédiaire est optionnelle. Elle peut notamment ne pas être nécessaire lorsqu'il existe une compatibilité chimique entre la première couche formant la face avant du module et l'ensemble encapsulant.

Avantageusement, la mise en oeuvre d'au moins deux étapes de laminage dans le procédé selon l'invention pour la réalisation du module photovoltaïque peut permettre de s'affranchir d'éventuels problèmes de dilatation thermique pouvant survenir du fait de l'utilisation d'une face avant du module en un matériau polymère.

En effet, certaines couches du module photovoltaïque nécessitent d'être laminées à une température supérieure ou égale à 140°C, voire 150°C, mais le laminage à ce niveau de température en une seule étape, conformément à la pratique selon l'art antérieur, de l'ensemble des couches du module, y compris celle formant la face avant du module, peut donner lieu à une conformation non contrôlée et à des délaminations importantes de la face avant du module photovoltaïque à cause de contraintes mécaniques engendrées trop importantes.

Aussi, la présence d'au moins une deuxième étape de laminage à plus basse température que pour la première étape, pour le laminage de la face avant du module photovoltaïque, éventuellement combinée à la présence d'une couche intermédiaire dite « amortissante » permettant le collage de la face avant du module sur le matériau d'encapsulation et l'amortissement des contraintes thermiques, peuvent permettre de limiter, voire d'empêcher, la dilatation thermique.

Alternativement, l'invention a aussi pour objet, selon un autre de ses aspects, un procédé de réalisation d'un module photovoltaïque tel que défini précédemment ou d'un ensemble de structure photovoltaïque tel que défini précédemment, comportant l'unique étape suivante de :
c) laminage à chaud à une température supérieure ou égale à 150°C de l'ensemble des couches constitutives du module photovoltaïque.

Pour la réalisation d'un ensemble de structure photovoltaïque tel que défini précédemment, les étapes a) et b), ou l'étape c), peuvent être suivies de l'étape d) de fixation du module photovoltaïque sur un support rigide pour former l'ensemble de structure photovoltaïque, au moyen d'une couche de fixation de l'ensemble de structure photovoltaïque, constituée par exemple par une colle bitumeuse.

Comme indiqué précédemment, l'épaisseur de l'ensemble encapsulant est entre 0,4 et 1 mm, celui-ci résultant de l'association par laminage d'au moins deux couches de matériau d'encapsulation présentant chacune une épaisseur comprise entre 0,2 et 0,5 mm. Ces deux couches de matériau d'encapsulation peuvent par ailleurs présenter des épaisseurs différentes.

Le module photovoltaïque, l'ensemble de structure photovoltaïque et le procédé selon l'invention peuvent comporter l'une quelconque des caractéristiques précédemment énoncées, prises isolément ou selon toutes combinaisons techniquement possibles avec d'autres caractéristiques.

### BRÈVE DESCRIPTION DU DESSIN

L'invention pourra être mieux comprise à la lecture de la description détaillée qui va suivre, d'un exemple de mise en oeuvre non limitatif de celle-ci, ainsi qu'à l'examen de la figure unique, schématique et partielle, du dessin annexé, illustrant, en coupe et en vue éclatée, un exemple de réalisation d'un ensemble de structure photovoltaïque comportant un module photovoltaïque conforme à l'invention.

Sur cette figure unique, les différentes parties représentées ne le sont pas nécessairement selon une échelle uniforme, pour rendre la figure plus lisible.

### EXPOSÉ DÉTAILLÉ D'UN MODE DE RÉALISATION PARTICULIER

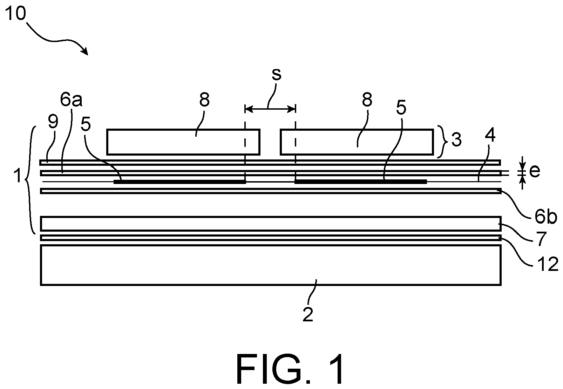

Il est fait ci-après référence à la figure 1, illustrant en coupe et en vue éclatée un exemple de réalisation d'un ensemble 10 de structure photovoltaïque comportant un module photovoltaïque 1 conforme à l'invention.

Il est à noter que la figure 1 correspond à une vue éclatée de l'ensemble 10 de structure photovoltaïque avant les étapes de laminage du procédé selon l'invention. Une fois les étapes de laminage réalisées, les différentes couches sont en réalité superposées les unes aux autres, mais aussi un peu déformées de sorte qu'au moins les plaques 8 de la première couche 3 s'enfoncent dans l'ensemble formé par la couche intermédiaire 9 et l'ensemble encapsulant 6a, 6b qui se déforment. Les étapes de laminage assurent un pressage à chaud et sous vide. Selon les épaisseurs des différentes couches, les plaques 8 peuvent affleurer ou non sur le module photovoltaïque 1, le matériau de la couche intermédiaire 9 et peut-être celui de l'ensemble encapsulant 6a, 6b pouvant également combler au moins une partie des espaces entre les plaques 8.

Comme expliqué précédemment, le module photovoltaïque 1 conforme à l'invention est conçu pour être suffisamment flexible afin de pouvoir l'appliquer, notamment par collage, sur un support rigide 2, pouvant présenter une rugosité de surface, autrement dit pas nécessairement plan et lisse. De plus, le module photovoltaïque 1 conforme à l'invention est également prévu pour résister à des pressions statiques ou dynamiques pouvant aller jusqu'à 1500 kN/m², voire 5000 kN/m². Le support rigide 2 est de manière avantageuse suffisamment rigide pour ne pas se déformer lorsqu'on applique la même contrainte que celle appliquée au module photovoltaïque 1. Il peut par exemple être formé par un revêtement de toiture, être en béton ou en tôle métallique, entre autres.

Comme on peut ainsi le voir sur la figure 1, le module photovoltaïque 1 comporte une première couche 3 transparente formant la face avant du module 1 destinée à recevoir un flux lumineux, un ensemble encapsulant 6a, 6b, obtenu par la fusion de deux couches de matériau d'encapsulation supérieure 6a et inférieure 6b, un ensemble 4 de cellules photovoltaïques 5 pris entre les deux couches de matériau d'encapsulation supérieure 6a et inférieure 6b, et une deuxième couche 7 formant la face arrière du module photovoltaïque 1 destinée à être collée au support rigide 2.

Les deux couches de matériau d'encapsulation 6a et 6b formant l'ensemble encapsulant, ainsi que l'éventuelle couche intermédiaire 9 décrite par la suite, forment une structure relativement souple pouvant être réalisée à partir d'un seul matériau ou de plusieurs matériaux en cas d'incompatibilité chimique.

Conformément à l'invention, la première couche 3 est constituée d'un matériau polymère transparent et comporte une pluralité de plaques 8 indépendantes les unes des autres, chaque plaque 8 étant située en regard d'une cellule photovoltaïque 5, de sorte à former une face avant discontinue du module photovoltaïque 1.

Le matériau polymère transparent de la première couche 3 peut par exemple être choisi parmi du polycarbonate (PC), du polyméthacrylate de méthyle (PMMA), de l'éthylène tétrafluoroéthylène (ETFE), ou du polyfluorure de vinylidène (PVDF), entre autres. De plus, l'épaisseur de la première couche 3 peut être supérieure à 0,1 mm, et idéalement comprise entre 0,5 et 6 mm. Dans cet exemple, la première couche 3 est ainsi constituée de plusieurs plaques 8, de dimensions égales à 162 x 162 mm, de PMMA d'épaisseur égale à 3 mm.

Par ailleurs, les cellules photovoltaïques 5 sont interconnectées électriquement les unes avec les autres avec un espacement s entre deux cellules 5 voisines compris entre 1 et 30 mm. Les cellules photovoltaïques 5 peuvent être des cellules dites « cristallines », c'est-à-dire à base de cristaux de silicium ou de polycristaux de silicium, avec une homojonction ou hétérojonction, et d'épaisseur inférieure ou égale à 250 µm. De plus, dans cet exemple, chaque plaque 8 s'étend en superposition de part et d'autre de la cellule photovoltaïque 5 sous-jacente sur une distance d'environ 3 mm, de sorte que l'espacement entre deux plaques 8 adjacentes est ici égal à l'espacement s entre deux cellules 5 voisines diminué d'environ 2 fois 3 mm, soit environ 6 mm.

En outre, la rigidité de chaque couche de matériau d'encapsulation 6a et 6b est définie par un module de Young E à température ambiante du matériau d'encapsulation supérieur ou égal à 75 MPa, voire encore 100 MPa, de préférence supérieur ou égal à 200 MPa, et une épaisseur e de la couche 6a, 6b comprise entre 0,2 et 1 mm.

Les couches de matériau d'encapsulation 6a et 6b forment un ensemble encapsulant préférentiellement choisi pour être un ionomère tel que le ionomère commercialisé sous le nom de ionomère jurasol® de type DG3 par la société Jura-plast ou le ionomère commercialisé sous le nom de PV5414 par la société Du Pont, présentant un module de Young à température ambiante supérieur ou égal à 200 MPa et une épaisseur d'environ 500 µm.

La deuxième couche 7 formant la face arrière du module photovoltaïque 1 est quant à elle constituée par un matériau polymère tel que des résines thermodurcissables comme des résines à base époxy, transparent ou non, ou un matériau composite, par exemple du type polymère/fibres de verre. Dans cet exemple, la deuxième couche 7 est constituée par un matériau composite du type polymère/fibres de verre, notamment un tissu à base de polypropylène et de fibres de verre avec un taux de fibres de verre de 60 % en masse, tel que le Thermopreg® fabric P-WRt-1490-PP60W commercialisé par la société Owens Corning Vetrotex, ayant une épaisseur d'environ 1 mm et un module de Young à température ambiante d'environ 12 GPa.

Par ailleurs, bien que non représentée, une éventuelle couche adhésive, ou encore compatibilisante (sa présence étant justifiée en cas d'incompatibilité chimique), peut être située entre la deuxième couche 7 formant la face arrière du module photovoltaïque 1 et l'ensemble encapsulant formé par les deux couches de matériau d'encapsulation 6a et 6b de part et d'autre de l'ensemble 4 de cellules photovoltaïques 5. Cette couche compatibilisante peut permettre le collage de la deuxième couche 7 sur la couche de matériau d'encapsulation inférieure 6b. Dans le cas de l'utilisation du Thermopreg® fabric P-WRt-1490-PP60W pour la deuxième couche 7, la couche compatibilisante peut préférentiellement être choisie pour être un film du type Mondi TK41001 ayant une épaisseur d'environ 50 µm.

De plus, comme on peut le voir sur la figure 1, le module photovoltaïque 1 comporte également une couche intermédiaire 9 dite « amortissante » située entre la première couche 3 et l'ensemble encapsulant formé par les deux couches de matériau d'encapsulation 6a et 6b de part et d'autre de l'ensemble 4 de cellules photovoltaïques 5.

La couche intermédiaire 9 est optionnelle et trouve essentiellement son utilité s'il existe une incompatibilité chimique entre la première couche 3 et la couche de matériau d'encapsulation supérieure 6a.

La couche intermédiaire 9 permet le collage de la première couche 3 sur la couche de matériau d'encapsulation supérieure 6a.

La couche intermédiaire 9 est par exemple constituée par un encapsulant standard utilisé dans le domaine du photovoltaïque, tel que le copolymère de l'éthylène-acétate de vinyle (EVA), une polyoléfine, du silicone, du polyuréthane thermoplastique, du polyvinyle de butyral, entre autres. Elle peut encore être constituée par une résine liquide de type acrylique, silicone ou polyuréthane, monocomposant ou bicomposant, réticulable à chaud, photochimiquement ou bien à froid (i.e. à température ambiante). Elle peut également être constituée par un adhésif sensible à la pression du type PSA (pour « Pressure-Sensitive Adhesive » en anglais).

Dans cet exemple, la couche intermédiaire 9 est constituée par un film thermoplastique, à savoir du polyuréthane thermoplastique connu également sous l'acronyme anglo-saxon TPU, tel que le TPU de type TPU Dureflex® A4700 commercialisé par la société Bayer ou le PX1001 commercialisé par la société American Polyfilm, d'épaisseur égale à environ 380 µm.

La couche intermédiaire 9 permet de remplir deux fonctions principales. D'une part, elle permet l'adhésion de la première couche 3 sur la couche de matériau d'encapsulation supérieure 6a pour le cas où les deux couches ne sont pas compatibles chimiquement. D'autre part, elle permet de créer au sein du module photovoltaïque 1 une couche « amortissante » d'une certaine souplesse permettant d'améliorer la résistance aux chocs et aux charges mécaniques du module 1.

Par ailleurs, l'ensemble 10 de structure photovoltaïque conforme à l'invention représenté sur la figure 1 comporte également un support rigide 2. Le support rigide 2 peut être de tout type de matière. Il peut être plan ou courbé, lisse ou rugueux.

Afin de permettre le collage du module photovoltaïque 1 sur le support rigide 2, l'ensemble 10 comporte également une couche de fixation 12. Cette couche de fixation 12 est constituée par une colle d'adhérence du module 1 au support rigide 2.

On va maintenant décrire un procédé de réalisation d'un module photovoltaïque 1 et d'un ensemble 10 de structure photovoltaïque conforme à l'invention.

Le procédé comporte une première étape a) de laminage à chaud à une température d'environ 170°C et sous vide (pression inférieure ou égale à 10 mbar) des couches constitutives 6a, 4, 6b et 7 du module photovoltaïque 1 hormis la première couche 3 et la couche intermédiaire 9. Cette première étape a) de laminage est réalisée pendant environ 15 minutes de manière à obtenir un « laminé » de cellules photovoltaïques 5 encapsulées. Les paramètres du laminage, tels que la température, le temps et la pression, peuvent toutefois dépendre du matériau encapsulant utilisé.

Puis, le procédé comporte une deuxième étape b) de laminage à chaud à une température d'environ 125°C et sous vide du « laminé » obtenu au cours de la première étape a) avec la première couche 3 formant la face avant du module photovoltaïque 1 à l'aide de la couche intermédiaire 9. Cette deuxième étape b) est réalisée pendant une durée d'environ 30 minutes de façon à obtenir le module photovoltaïque 1 selon l'invention. Avant la mise en oeuvre de cette deuxième étape b), les plaques 8 de la première couche 3 peuvent avantageusement être traitées à l'aide d'un équipement de traitement Corona de manière à obtenir une énergie de surface supérieure ou égale à 48 dyn/cm.

Ces première a) et deuxième b) étapes de laminage sont ensuite suivies d'une étape de fixation du module photovoltaïque 1 sur le support rigide 2 qui permet de former l'ensemble 10 de structure photovoltaïque.

Par conséquent, le module photovoltaïque 1 conforme à l'invention peut présenter une résistance mécanique accrue adaptée à des applications contraignantes en termes de sollicitations mécaniques, comme du type de la route solaire, mais également présenter une flexibilité par morceaux du fait de la présence d'une face avant 3 discontinue, lui permettant de prendre différentes formes pour s'adapter à différents types de surfaces, par exemple accidentées ou de planéité imparfaite. De plus, la présence d'une face arrière 7 renforcée peut permettre d'améliorer la résistance au poinçonnement de cette face arrière 7 du module 1, ce poinçonnement pouvant résulter de la rugosité du support 2 sur lequel le module 1 est appliqué et pouvant conduire à des fissures des cellules photovoltaïques 5 du module photovoltaïque 1.

Bien entendu, l'invention n'est pas limitée à l'exemple de réalisation qui vient d'être décrit. Diverses modifications peuvent y être apportées par l'homme du métier.

L'expression « comportant un » doit être comprise comme étant synonyme de « comportant au moins un », sauf si le contraire est spécifié.

## Revendications

1. Module photovoltaïque (1) comportant au moins :
- une première couche (3) transparente formant la face avant du module photovoltaïque (1) destinée à recevoir un flux lumineux,
- un ensemble (4) d'une pluralité de cellules photovoltaïques (5) disposées côte à côte et reliées électriquement entre elles,
- un ensemble encapsulant (6a, 6b) la pluralité de cellules photovoltaïques (5),
- une deuxième couche (7) formant la face arrière du module photovoltaïque (1), l'ensemble encapsulant (6a, 6b) et l'ensemble (4) d'une pluralité de cellules photovoltaïques (5) étant situés entre les première (3) et deuxième (7) couches, **caractérisé en ce que** la première couche (3) est constituée d'au moins un matériau polymère transparent et comporte une pluralité de plaques (8) indépendantes les unes des autres, chaque plaque (8) étant située en regard d'au moins une cellule photovoltaïque (5), de sorte à former une face avant discontinue du module photovoltaïque (1),
et **en ce que** la rigidité de l'ensemble encapsulant (6a, 6b) est définie par un module de Young (E) du matériau d'encapsulation supérieur ou égal à 75 MPa à température ambiante et une épaisseur de l'ensemble encapsulant (6a, 6b) comprise entre 0,4 et 1 mm.

2. Module selon la revendication 1, **caractérisé en ce que** le matériau d'encapsulation des couches formant l'ensemble encapsulant (6a, 6b) présente un module de Young (E) à température ambiante supérieur ou égal à 100 MPa, de préférence supérieur ou égal à 150 MPa, de préférence supérieur ou égal à 200 MPa, notamment égal à 220 MPa.

3. Module selon la revendication 1 ou 2, **caractérisé en ce que** la deuxième couche (7) formant la face arrière du module photovoltaïque (1) est constituée d'au moins un matériau polymère.

4. Module selon la revendication 1 ou 2, **caractérisé en ce que** la deuxième couche (7) formant la face arrière du module photovoltaïque (1) est constituée d'au moins un matériau composite, notamment du type polymère/fibres de verre.

5. Module selon l'une quelconque des revendications précédentes, **caractérisé en ce que** la rigidité de la deuxième couche (7) formant la face arrière du module photovoltaïque (1) est définie par un facteur de rigidité, correspondant au module de Young (E) à température ambiante du matériau de la deuxième couche (7) multiplié par l'épaisseur de la deuxième couche (7), compris entre 5 et 15 GPa.mm.

6. Module selon l'une quelconque des revendications précédentes, **caractérisé en ce que** l'espacement (s) entre deux cellules photovoltaïques (5) voisines est supérieur ou égal à 1 mm, notamment compris entre 1 et 30 mm, et de préférence supérieur ou égal à 3 mm, notamment compris entre 10 et 20 mm.

7. Module selon l'une quelconque des revendications précédentes, **caractérisé en ce qu'**il comporte une couche intermédiaire (9) dite « amortissante » située entre la première couche (3) formant la face avant du module photovoltaïque (1) et l'ensemble encapsulant (6a, 6b) la pluralité de cellules photovoltaïques (5), permettant l'assemblage, notamment par collage, de la première couche (3) sur l'ensemble encapsulant (6a, 6b).

8. Module selon la revendication 7, **caractérisé en ce que** la couche intermédiaire (9) est constituée d'au moins un matériau polymère, notamment d'une résine polymère thermoplastique ou thermodurcissable.

9. Module selon la revendication 7 ou 8, **caractérisé en ce que** la rigidité de la couche intermédiaire (9) est définie par un module de Young (E) du matériau de la couche intermédiaire (9) inférieur ou égal à 50 MPa à température ambiante et une épaisseur de la couche intermédiaire (9) comprise entre 0,01 et 1 mm.

10. Module selon l'une quelconque des revendications précédentes, **caractérisé en ce que** l'épaisseur de la première couche (3) formant la face avant du module photovoltaïque (1) est supérieure ou égale à 0,1 mm, notamment comprise entre 0,5 et 6 mm.

11. Ensemble (10) de structure photovoltaïque, comportant :
- un support rigide (2),
- un module photovoltaïque (1) selon l'une quelconque des revendications précédentes, et
- une couche de fixation (12) située entre le support rigide (2) et le module photovoltaïque (1), permettant l'adhérence du module photovoltaïque (1) au support rigide (2).

12. Utilisation, pour son application sur un support rigide (2) d'un module photovoltaïque (1) comportant au moins :
- une première couche (3) transparente formant la face avant du module photovoltaïque (1) destinée à recevoir un flux lumineux,
- un ensemble (4) d'une pluralité de cellules photovoltaïques (5) disposées côte à côte et reliées électriquement entre elles,
- un ensemble encapsulant (6a, 6b) la pluralité de cellules photovoltaïques (5),
- une deuxième couche (7) formant la face arrière du module photovoltaïque (1), l'ensemble encapsulant (6a, 6b) et l'ensemble (4) d'une pluralité de cellules photovoltaïques (5) étant situés entre les première (3) et deuxième (7) couches,
la première couche (3) étant constituée d'au moins un matériau polymère transparent comportant une pluralité de plaques (8) indépendantes les unes des autres, chaque plaque (8) étant située en regard d'au moins une cellule photovoltaïque (5), de sorte à former une face avant discontinue du module photovoltaïque (1),
et la rigidité de l'ensemble encapsulant (6a, 6b) étant définie par un module de Young (E) du matériau d'encapsulation supérieur ou égal à 75 MPa à température ambiante et une épaisseur (e) de l'ensemble encapsulant (6a, 6b) comprise entre 0,4 et 1 mm,
le module photovoltaïque (1) étant appliqué sur le support rigide (2) par l'intermédiaire d'une couche de fixation (12).

13. Procédé de réalisation d'un module photovoltaïque (1) selon l'une quelconque des revendications 1 à 10, comportant au moins les deux étapes successives suivantes de :
a) laminage à chaud à une température supérieure à 150°C de l'ensemble des couches (6a, 4, 6b, 7) constitutives du module photovoltaïque (1) hormis la première couche (3) formant la face avant du module photovoltaïque (1) et une éventuelle couche intermédiaire (9) dite « amortissante », située entre la première couche (3) et l'ensemble encapsulant (6a, 6b) la pluralité de cellules photovoltaïques (5),
b) laminage à une température strictement inférieure ou égale à 150°C, de préférence 125°C, de la première couche (3) formant la face avant du module photovoltaïque (1), et de l'éventuelle couche intermédiaire (9), sur les couches (6a, 4, 6b, 7) constitutives du module photovoltaïque (1) laminées ensemble au cours de la première étape a).

14. Procédé de réalisation d'un module photovoltaïque (1) selon l'une quelconque des revendications 1 à 10, comportant l'unique étape suivante de :
c) laminage à chaud à une température supérieure ou égale à 150°C de l'ensemble des couches (3, 9, 6a, 4, 6b, 7) constitutives du module photovoltaïque (1).

15. Procédé de réalisation d'un ensemble (10) de structure photovoltaïque selon la revendication 11, mettant en oeuvre les étapes du procédé selon la revendication 13 ou 14, et comportant successivement l'étape d) suivante de :
d) fixation du module photovoltaïque (1) sur un support rigide (2) pour former l'ensemble (10) de structure photovoltaïque, au moyen d'une couche de fixation (12) de l'ensemble (10) de structure photovoltaïque.

## Patentansprüche

1. Fotovoltaikmodul (1), zumindest enthaltend:
- eine transparente erste Schicht (3), welche die Vorderseite des Fotovoltaikmoduls (1) bildet, die dazu bestimmt ist, einen Lichtstrom aufzunehmen,
- eine Anordnung (4) aus einer Mehrzahl von Fotovoltaikzellen (5), die nebeneiner angeordnet und elektrisch miteinander verbunden sind,
- eine Anordnung (6a, 6b), welche die Mehrzahl der Fotovoltaikzellen (5) einkapselt,
- eine zweite Schicht (7), welche die Rückseite des Fotovoltaikmoduls (1) bildet, wobei die Kapselungsanordnung (6a, 6b) und die Anordnung (4) aus der Mehrzahl von Fotovoltaikzellen (5) zwischen der ersten (3) und der zweiten Schicht (7) liegen,
**dadurch gekennzeichnet, dass** die erste Schicht (3) aus zumindest einem transparenten Polymermaterial besteht und eine Mehrzahl von voneinander unabhängigen Platten (8) enthält, wobei jede Platte (8) zumindest einer Fotovoltaikzelle (5) gegenüberliegt, so dass sie eine nicht durchgehende Vorderseite des Fotovoltaikmoduls (1) bildet,
und dass die Steifigkeit der Kapselungsanordnung (6a, 6b) von einem Elastizitätsmodul (E) des Kapselungsmaterials, der größer oder gleich 75 MPa bei Raumtemperatur ist, und von einer Dicke der Kapselungsanordnung (6a, 6b) bestimmt wird, die zwischen 0,4 und 1 mm beträgt.

2. Modul nach Anspruch 1, **dadurch gekennzeichnet, dass** das Kapselungsmaterial der die Kapselungsanordnung (6a, 6b) bildenden Schichten einen Elastizitätsmodul (E) bei Raumtemperatur aufweist, der größer oder gleich 100 MPa, vorzugsweise größer oder gleich 150 MPa, vorzugsweise größer oder gleich 200 MPa, insbesondere gleich 220 MPa, ist.

3. Modul nach Anspruch 1 oder 2, **dadurch gekennzeichnet, dass** die zweite Schicht (7), welche die Rückseite des Fotovoltaikmoduls (1) bildet, aus zumindest einem Polymermaterial besteht.

4. Modul nach Anspruch 1 oder 2, **dadurch gekennzeichnet, dass** die zweite Schicht (7), welche die Rückseite des Fotovoltaikmoduls (1) bildet, aus zumindest einem Verbundmaterial, insbesondere vom Typ Polymer/Glasfasern, besteht.

5. Modul nach einem der vorangehenden Ansprüche, **dadurch gekennzeichnet, dass** die Steifigkeit der zweiten Schicht (7), welche die Rückseite des Fotovoltaikmoduls (1) bildet, von einem Steifigkeitsfaktor bestimmt wird, welcher dem Elastizitätsmodul (E) des Materials der zweiten Schicht (7) bei Raumtemperatur, multipliziert mit der Dicke der zweiten Schicht (7), entspricht und zwischen 5 und 15 GPa.mm beträgt.

6. Modul nach einem der vorangehenden Ansprüche, **dadurch gekennzeichnet, dass** der Abstand (s) zwischen zwei benachbarten Fotovoltaikzellen (5) größer oder gleich 1 mm ist, insbesondere zwischen 1 und 30 mm beträgt, und vorzugsweise größer oder gleich 3 mm ist, insbesondere zwischen 10 und 20 mm beträgt.

7. Modul nach einem der vorangehenden Ansprüche, **dadurch gekennzeichnet, dass** es eine sogenannte "dämpfende" Zwischenschicht (9) enthält, die zwischen der die Vorderseite des Fotovoltaikmoduls (1) bildenden ersten Schicht (3) und der die Mehrzahl von Fotovoltaikzellen (5) einkapselnden Anordnung (6a, 6b) liegt, wodurch das Anfügen der ersten Schicht (3) an die Kapselungsanordnung (6a, 6b), insbesondere durch Verkleben, möglich ist.

8. Modul nach Anspruch 7, **dadurch gekennzeichnet, dass** die Zwischenschicht (9) aus zumindest einem Polymermaterial, insbesondere einem thermoplastischen bzw. duroplastischen Polymerharz, besteht.

9. Modul nach Anspruch 7 oder 8, **dadurch gekennzeichnet, dass** die Steifigkeit der Zwischenschicht (9) von einem Elastizitätsmodul (E) des Materials der Zwischenschicht (9), der kleiner oder gleich 50 MPa bei Raumtemperatur ist, und von einer Dicke der Zwischenschicht (9) zwischen 0,01 und 1 mm bestimmt wird.

10. Modul nach einem der vorangehenden Ansprüche, **dadurch gekennzeichnet, dass** die Dicke der ersten Schicht (3), welche die Vorderseite des Fotovoltaikmoduls (1) bildet, größer oder gleich 0,1 mm ist, insbesondere zwischen 0,5 und 6 mm beträgt.

11. Fotovoltaische Strukturanordnung (10), enthaltend:
- einen starren Träger (2),
- ein Fotovoltaikmodul (1) nach einem der vorangehenden Ansprüche, und
- eine Fixierungsschicht (12), die zwischen dem starren Träger (2) und dem Fotovoltaikmodul (1) liegt und das Anhaften des Fotovoltaikmoduls (1) an den starren Träger (2) gestattet.

12. Verwendung eines Fotovoltaikmoduls (1) zu dessen Aufbringen auf einen starren Träger (2), zumindest enthaltend:
- eine transparente erste Schicht (3), welche die Vorderseite des Fotovoltaikmoduls (1) bildet, die dazu bestimmt ist, einen Lichtstrom aufzunehmen,
- eine Anordnung (4) aus einer Mehrzahl von Fotovoltaikzellen (5), die nebeneiner angeordnet und elektrisch miteinander verbunden sind,
- eine Anordnung (6a, 6b), welche die Mehrzahl der Fotovoltaikzellen (5) einkapselt,
- eine zweite Schicht (7), welche die Rückseite des Fotovoltaikmoduls (1) bildet, wobei die Kapselungsanordnung (6a, 6b) und die Anordnung (4) aus der Mehrzahl von Fotovoltaikzellen (5) zwischen der ersten (3) und der zweiten Schicht (7) liegen,
wobei die erste Schicht (3) aus zumindest einem transparenten Polymermaterial besteht und eine Mehrzahl von voneinander unabhängigen Platten (8) enthält, wobei jede Platte (8) zumindest einer Fotovoltaikzelle (5) gegenüberliegt, so dass sie eine nicht durchgehende Vorderseite des Fotovoltaikmoduls (1) bildet,
und wobei die Steifigkeit der Kapselungsanordnung (6a, 6b) von einem Elastizitätsmodul (E) des Kapselungsmaterials, der größer oder gleich 75 MPa bei Raumtemperatur ist, und von einer Dicke (e) der Kapselungsanordnung (6a, 6b) bestimmt wird, die zwischen 0,4 und 1 mm beträgt,
wobei das Fotovoltaikmodul (1) mittels einer Fixierungsschicht (12) auf den starren Träger (2) aufgebracht wird.

13. Verfahren zum Herstellen eines Fotovoltaikmoduls (1) nach einem der Ansprüche 1 bis 10, umfassend zumindest die beiden nachstehenden, aufeinanderfolgenden Schritte:
a) Heißlaminieren der Anordnung von das Fotovoltaikmodul (1) bildenden Schichten (6a, 4, 6b, 7) bei einer Temperatur von über 150°C, abgesehen von der die Vorderseite des Fotovoltaikmoduls (1) bildenden ersten Schicht (3) und einer eventuellen sogenannten "dämpfenden" Zwischenschicht (9), die zwischen der ersten Schicht (3) und der die Mehrzahl von Fotovoltaikzellen (5) einkapselnden Anordnung (6a, 6b) liegt,
b) Laminieren der die Vorderseite des Fotovoltaikmoduls (1) bildenden ersten Schicht (3) und der eventuellen Zwischenschicht (9) bei einer Temperatur strikt geringer oder gleich 150 °C, vorzugsweise 125°C, auf die das Fotovoltaikmodul (1) bildenden Schichten (6a, 4, 6b, 7), die im Laufe des ersten Schritts a) laminiert wurden.

14. Verfahren zum Herstellen eines Fotovoltaikmoduls (1) nach einem der Ansprüche 1 bis 10, umfassend den einzigen nachstehenden Schritt:
c) Heißlaminieren der das Fotovoltaikmodul (1) bildenden Anordnung von Schichten (3, 9, 6a, 4, 6b, 7) bei einer Temperatur höher oder gleich 150°C.

15. Verfahren zum Herstellen einer fotovoltaischen Strukturanordnung (10) nach Anspruch 11, wobei die Verfahrensschritte nach Anspruch 13 oder 14 durchgeführt werden, und nachfolgend umfassend den nachstehenden Schritt d):
d) Fixieren des Fotovoltaikmoduls (1) an einen starren Träger (1) zum Ausbilden der fotovoltaischen Strukturanordnung (10) mittels einer Fixierungsschicht (12) zum Fixieren der fotovoltaischen Strukturanordnung (10).

## Claims

1. Photovoltaic module (1) including at least:
- a transparent first layer (3) forming the front face of the photovoltaic module (1) intended to receive the light flux,
- an assembly (4) of several photovoltaic cells (5) arranged side by side and connected together electrically,
- an encapsulated assembly (6a, 6b) of the several photovoltaic cells (5),
- a second layer (7) forming the rear face of the photovoltaic module (1), the encapsulating assembly (6a, 6b) and the assembly (4) of several photovoltaic cells (5) being located between the first (3) and second (7) layers,
**Characterised in that** the first layer (3) consists of at least a transparent polymer material and includes several plates (8) independent from one another, each plate (8) being located opposite at least one photovoltaic cell (5), such as to form a discontinuous front face for the photovoltaic module (1),
and **in that** the rigidity of the encapsulating assembly (6a, 6b) is defined by a Young's modulus (E) of the encapsulation material greater than or equal to 75 MPa at ambient temperature and a thickness of the encapsulating assembly (6a, 6b) of between 0.4 and 1 mm.

2. Module in accordance with claim 1, **characterised in that** the encapsulation material of the layers forming the encapsulating assembly (6a, 6b) exhibit a Young's modulus (E) at ambient temperature greater than or equal to 100 MPa, preferably greater than or equal to 150 MPa, preferably greater than or equal to 200 MPa, notably equal to 220 MPa.

3. Module according to claim 1 or 2, **characterised in that** the second layer (7) forming the rear face of the photovoltaic module (1) consists of at least one polymer material.

4. Module according to claim 1 or 2, **characterised in that** the second layer (7) forming the rear face of the photovoltaic module (1) consists of at least one composite material, in particular of the polymer/fibreglass type.

5. Module according to any of the above claims, **characterised in that** the rigidity of the second layer (7) forming the rear face of the photovoltaic module (1) is defined by a rigidity factor, corresponding to Young's modulus (E) at ambient temperature of the material of the second layer (7) multiplied by the thickness of the second layer (7), of between 5 and 15 GPa.mm.

6. Module according to any of the above claims, **characterised in that** the spacing (s) between two adjacent photovoltaic cells (5) is greater than or equal to 1 mm, in particular between 1 and 30 mm, and preferably greater than or equal to 3 mm, in particular between 10 and 20 mm.

7. Module according to any of the above claims, **characterised in that** it includes an intermediate so-called "damping" layer (9) located between the first layer (3) forming the front face of the photovoltaic module (1) and the encapsulating assembly (6a, 6b) of several photovoltaic cells (5), enabling the assembly, essentially by bonding, of the first layer (3) to the encapsulating assembly (6a, 6b).

8. Module according to claim 7, **characterised in that** the intermediate layer (9) consists of at least one polymer material, in particular a thermoplastic or thermosetting polymer resin.

9. Module according to claim 7 or 8, **characterised in that** the rigidity of the intermediate layer (9) is defined by the Young's modulus (E) of the material of the intermediate layer (9) less than or equal to 50 MPa at ambient temperature and a thickness of the intermediate layer (9) of between 0.01 and 1 mm.

10. Module according to any of the previous claims, **characterised in that** the thickness of the first layer (3) forming the front face of the photovoltaic module (1) is greater than or equal to 0.1 mm, in particular between 0.5 and 6 mm.

11. Photovoltaic structure assembly (10), including:
- a rigid backing (2),
- a photovoltaic module (1) according to any of the previous claims, and
- an attachment layer (12) located between the rigid backing (2) and the photovoltaic module (1), enabling adhesion of the photovoltaic module (1) to the rigid backing (2).

12. Use, for its application to a rigid backing (2) of a photovoltaic module (1) including at least:
- a transparent first layer (3) forming the front face of the photovoltaic module (1) intended to receive the light flux,
- an assembly (4) of several photovoltaic cells (5) arranged side by side and connected together electrically,
- an assembly (6a, 6b) encapsulating the several photovoltaic cells (5),
- a second layer (7) forming the rear face of the photovoltaic module (1), the encapsulating assembly (6a, 6b) and the assembly (4) of several photovoltaic cells (5) being located between the first (3) and second (7) layers,
The first layer (3) consisting of at least one transparent polymer material including several plates (8) independent from one another, each plate (8) being located opposite at least one photovoltaic cell (5), such as to form a discontinuous front face for the photovoltaic module (1),
and the rigidity of the encapsulating assembly (6a, 6b) being defined by a Young's modulus (E) of the encapsulation material greater than or equal to 75 MPa at ambient temperature and a thickness (e) of the encapsulating assembly (6a, 6b) of between 0.4 and 1 mm,
the photovoltaic module (1) being applied to the rigid backing (2) via an attachment layer (12).

13. Process for the production of a photovoltaic module (1) according to any of the claims 1 to 10, including at least the following two successive stages:
a) hot rolling at a temperature greater than 150°C of the constituent layers (6a, 4, 6b, 7) of the photovoltaic module (1) apart from the first layer (3) forming the front face of the photovoltaic module (1) and a possible intermediate so-called "damping" layer (9) located between the first layer (3) and the encapsulating assembly (6a, 6b) of several photovoltaic cells (5),
b) rolling at a temperature strictly less than or equal to 150°C, preferably 125°C, of the first layer (3) forming the front face of the photovoltaic module (1), and any intermediate layer (9), to the constituent layers (6a, 4, 6b, 7) of the photovoltaic module (1) rolled together during the first stage a).

14. Process for the production of a photovoltaic module (1) according to any of claims 1 to 10, including the following single stage:
c) hot rolling at a temperature greater than or equal to 150°C of all the constituent layers (3, 9, 6a, 4, 6b, 7) of the photovoltaic module (1).

15. Process for the production of a photovoltaic structure assembly (10) according to claim 11, using the stages of the process according to claim 13 or 14, and including successively the following stage d):
d) attachment of the photovoltaic module (1) to a rigid backing (2) to form the photovoltaic structure assembly (10), via the attachment layer (12) of the photovoltaic structure assembly (10).
